# EUROPEAN PATENT APPLICATION

(11) **EP 4 135 032 A1**
(43) Date of publication of application: **15.02.2023**
(21) Application number: 22187769.9
(22) Date of filing: 29.07.2022
(51) Int. Cl.: H01L 25/10, H01L 23/498, H01L 23/538, H01L 23/00, H01L 25/065

(54) **SEMICONDUCTOR PACKAGE WITH REDUCED CONNECTION LENGTH**

(30) Priority: 13.08.2021 US 202163232710 P; 18.07.2022 US 202217866566
(71) Applicant: MediaTek Inc., Hsin-Chu 300 (TW)
(72) Inventor: KUO, Che-Hung, 30078 Hsinchu City (TW); YANG, Chung-Min, 30078 Hsinchu City (TW)
(74) Representative: Hoefer & Partner Patentanwälte mbB

(57) **Abstract**

A semiconductor package (3) includes a logic die (500) surrounded by a molding compound (520); a memory die (600) disposed in proximity to the logic die (500); a plurality of vias (522v) around the logic die (500) for electrically connecting the logic die (500) to the memory die (600). Each of the plurality of vias (522v) has an oval shape or a rectangular shape when viewed from above. The vias (522v) have a horizontal pitch along a first direction and a vertical pitch along a second direction. The vertical pitch is greater than the horizontal pitch.

## Description

### Cross Reference to Related Applications

This application claims the benefit of U.S. Provisional Application No. 63/232,710, filed on August 13th, 2021. The content of the application is incorporated herein by reference.

### Background

The present disclosure relates generally to the field of semiconductor technology. More particularly, the present disclosure relates to a semiconductor package with reduced connection length.

Due to the fast growth in emerging markets for mobile applications, packaging technology has become more challenging than ever before, driving advanced Silicon (Si) nodes, finer bump pitch as well as finer line width and spacing substrate manufacturing capabilities to satisfy the increasing requirements in mobile devices.

Package on Package (PoP) technique has been used to combine discrete packages. PoP is typically composed of two packages, such as a top package containing a memory chip mounted on bottom package containing a logic chip. The top package may be connected to the bottom package through an interposer. It is desired to further reduce the length of the connection path between the logic chip and the memory chip in the PoP package structure in order to improve the electrical performance.

### Summary

One object of the present invention is to provide an improved semiconductor package with shortened length of electrical connection path in order to solve the above-mentioned prior art problems or shortcomings. Semiconductor packages according to the invention are defined in the independent claims. The dependent claims define preferred embodiments thereof.

One aspect of the invention provides a semiconductor package including a bottom package having an application processor (AP) die surrounded by a molding compound; a top package mounted on the bottom package; a top re-distribution layer (RDL) structure disposed between the top package and the bottom package; a plurality of through-molding vias (TMVs) disposed in the molding compound for electrically connecting the top package with the AP die; and a bottom RDL structure. Each of the plurality of TMVs has an oval shape or a rectangular shape when viewed from above. The AP die and the plurality of TMVs are interconnected to the bottom RDL structure.

Preferably, the top package is a memory package.

Preferably, the TMVs have a horizontal pitch along a first direction and a vertical pitch along a second direction, wherein the vertical pitch is greater than the horizontal pitch.

Preferably, the TMVs are aligned along the second direction.

Preferably, the TMVs are arranged in a staggered manner.

Preferably, a plurality of solder balls is disposed on a surface of the bottom RDL structure.

Another aspect of the invention provides a semiconductor package including a bottom package comprising a top 2-layer substrate, a middle molding compound, and a bottom multi-layer substrate to encapsulate an application processor (AP) die; a top package mounted on the bottom package; a plurality of through-molding vias (TMVs) disposed in the middle molding compound for electrically connecting the top package with the AP die. Each of the plurality of TMVs has an oval shape or a rectangular shape when viewed from above.

Preferably, the top package is a memory package.

Preferably, the TMVs have a horizontal pitch along a first direction and a vertical pitch along a second direction, wherein the vertical pitch is greater than the horizontal pitch.

Preferably, the TMVs are aligned along the second direction.

Preferably, the TMVs are arranged in a staggered manner.

Still another aspect of the invention provides a semiconductor package including at least one logic die surrounded by a molding compound; a memory device disposed in proximity to the at least one logic die; a plurality of vias around the at least one logic die for electrically connecting the at least one logic die to the memory device, wherein each of the plurality of vias has an oval shape or a rectangular shape when viewed from above.

Preferably, the vias have a horizontal pitch along a first direction and a vertical pitch along a second direction, wherein the vertical pitch is greater than the horizontal pitch.

Preferably, the vias are aligned along the second direction.

Preferably, the vias are arranged in a staggered manner.

Preferably, the semiconductor package further includes a top bridge substrate interconnected to the plurality of vias.

Preferably, the semiconductor package further includes a bridge via substrate interconnected to the at least one logic die.

Preferably, the semiconductor package further includes a through-silicon-via (TSV) die surrounded by the molding compound, wherein the plurality of vias is disposed in the molding compound.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary semiconductor package in accordance with an embodiment of the invention;
FIG. 2 is a schematic diagram showing a partial top view layout of the TMVs around the AP die in accordance with an embodiment of the invention;
FIG. 3 shows staggered TMVs arranged in 3x2 array;
FIG. 4 shows an exemplary HBPoP;
FIG. 5 illustrates an exemplary semiconductor package;
FIG. 6 illustrates another exemplary semiconductor package; and
FIG. 7 illustrates still another exemplary semiconductor package.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

The present disclosure pertains to semiconductor packages with reduced connection length, which are suited for applications including, but not limited to, fan-out package-on-package (fan-out PoP) and high-bandwidth package-on-package (HBPoP).

"Fan-Out" packaging can be defined as any package with connections fanned-out of the chip surface, enabling more external I/Os. Conventional fan-out packages use an epoxy mold compound to fully embed the dies, rather than placing them upon a substrate or interposer. Fan-Out packaging typically involves dicing chips on a silicon wafer, and then very precisely positioning the known-good chips on a thin "reconstituted" or carrier wafer, which is then molded and followed by a redistribution layer (RDL) atop the molded area (chip and fan-out area), and then forming solder balls on top. HBPoP typically includes a top 2-layer substrate, a middle molding and a bottom 3-layer substrate to encapsulate an application processor (AP) die. Compared to fan-out PoP, HBPoP has lower cost for AP packaging.

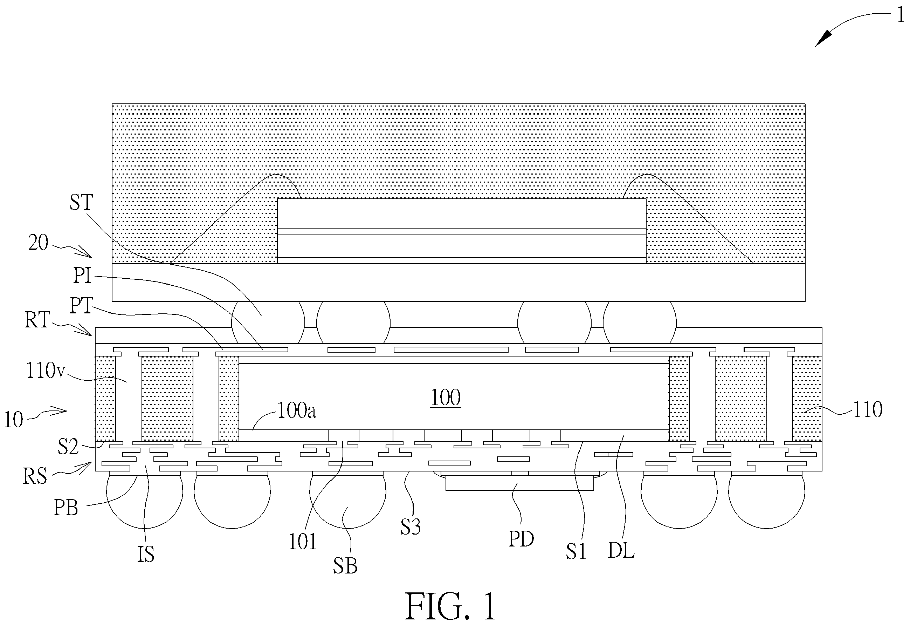

FIG. 1 is a schematic, cross-sectional diagram showing an exemplary semiconductor package in accordance with an embodiment of the invention. As shown in FIG. 1, the semiconductor package 1 may be a fan-out PoP, but is not limited thereto. Preferably, the semiconductor package 1 may comprise a bottom package 10 and a top package 20 mounted on the bottom package 10. For example, the bottom package 10 comprises an application processor (AP) die 100 surrounded by a molding compound 110. A dielectric layer DL may be disposed on an active surface 100 of the AP die 100. A plurality of conductive bumps or pillars 101 may be disposed in the dielectric layer DL and may be electrically coupled to the active surface 100a. The top surface S1 of the dielectric layer DL may be coplanar with the top surface S2 of the surrounding molding compound 110 after performing grinding or chemical mechanical polishing (CMP) process.

Preferably, a re-distributed layer (RDL) structure RS may be disposed on the top surface S1 of the dielectric layer DL and the top surface S2 of the surrounding molding compound 110. The RDL structure RS may comprise multiple layers of interconnect IS. Preferably, a plurality of ball pads PB may be distributed on the top surface S3 of the RDL structure RS. A solder ball SB may be mounted on each of the ball pads PB for further connection. Optionally, a passive element PD such as a decoupling capacitor or any suitable surface mount devices (SMDs) may be disposed on the top surface S3 of the RDL structure RS among the solder balls SB.

Preferably, a plurality of through molding vias (TMVs) 110v is disposed in the molding compound 110 to electrically connect the RDL structure RS to the overlying re-distributed layer (RDL) structure RT. Preferably, the RDL structure RT may at least comprise a plurality of bump pads PI and metal traces PT for connecting the bump pads PI with the TMVs 110v. The top package 20 is mounted on the bump pads PI through the bumps ST such as micro-bumps. Preferably, for example, the top package 20 may be a DRAM package such as a DDR DRAM package. In some embodiments, the TMVs 110v may be interposer pillars or solder joints.

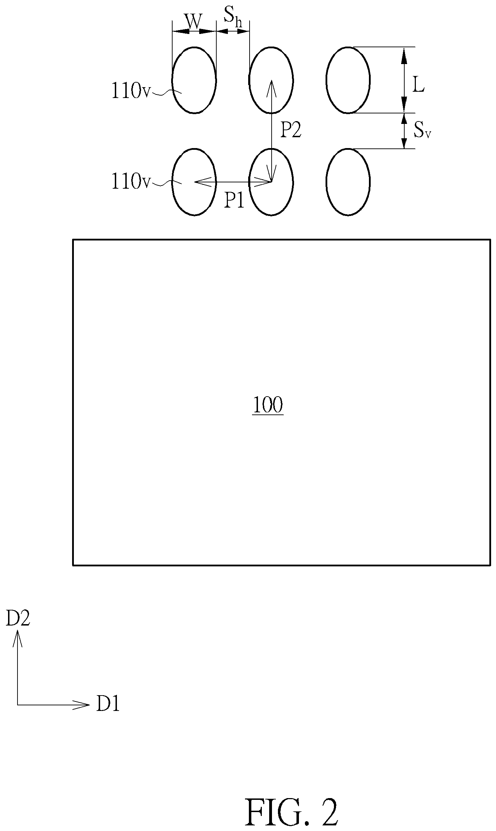

Please refer to FIG. 2. FIG. 2 is a schematic diagram showing a partial top view layout of the TMVs 110v around the AP die 100 in FIG. 1 in accordance with an embodiment of the invention. As shown in FIG. 2, when viewed from the above, each of the TMVs 110v may have an oval shape or a rectangular shape. Each of the TMVs 110v elongates along the second direction D2 or the via-to-die direction. The maximum length of each of the TMVs 110v is L and the maximum width of each of the TMVs 110v is W, wherein L is greater than W.

Preferably, the TMVs 110v in an exemplary 3x2 array may have a horizontal pitch P1 of W+ Sₕ along the first direction D1 (i.e. the direction in parallel with an adjacent side edge of the AP die 100), wherein Sₕ is the space between two neighboring TMVs 110v along the first direction D1. Preferably, the TMVs 110v in a 3x2 array may have a vertical pitch P2 of L+ Sᵥ along the second direction D2, wherein Sᵥ is the space between two neighboring TMVs 110v along the second direction D2. Preferably, the first direction D1 is orthogonal to the second direction D2. Preferably, the vertical pitch P2 is greater than the horizontal pitch P1 of the TMVs 110v.

By providing such configuration, TMVs 110v can be arranged around the AP die 100 in a more closely packed manner than the prior art. The connection length between the memory package 20 and the AP die 100 can be reduced because of the oval shaped TMV 110v, especially to those TMVs 100v disposed at a peripheral region or at an corner region of the semiconductor package 1.

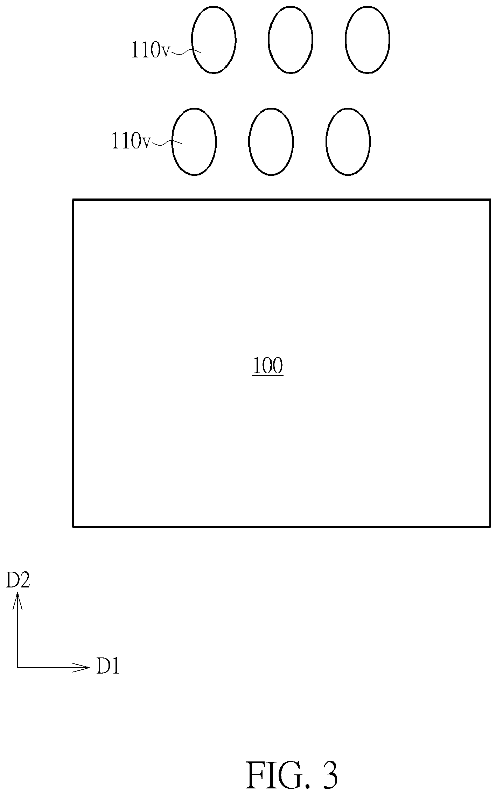

For the sake of simplicity, only a 3x2 array of the TMVs 110v is illustrated. Preferably, the two rows of the TMVs 110v may be aligned to each other in the second direction D2.Alternatively preferably, as shown in FIG. 3, the 3x2 array of the TMVs 110v may be staggered, that is, the front row is offset from the rear row.

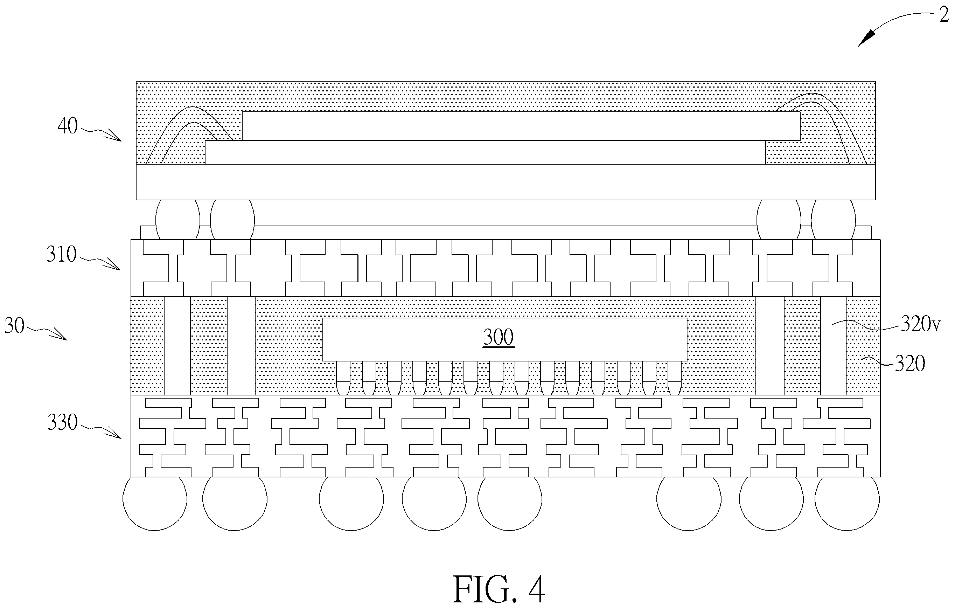

The oval-shaped TMVs 110v as depicted in FIG. 2 and FIG. 3 may be applicable to other kinds of semiconductor packages such as HBPoP. FIG. 4 illustrates an exemplary HBPoP. As shown in FIG. 4, the HBPoP 2 has a bottom package 30 and a top package 40 such as a DRAM package mounted on the bottom package 30. The bottom package 30 comprises a top 2-layer substrate 310, a middle molding compound 320, and a bottom multi-layer substrate 330 to encapsulate an application processor (AP) die 300. Likewise, a plurality of TMVs 320v is disposed around the AP die 300. The TMVs 320v are disposed in the molding compound 320 and are used to electrically connect the top 2-layer substrate 310 with the bottom multi-layer substrate 330. The MVs 320v disposed in the middle molding compound electrically connect the top package with the AP die, wherein each of the plurality of TMVs has an oval shape, a rectangle shape or a combination thereof.

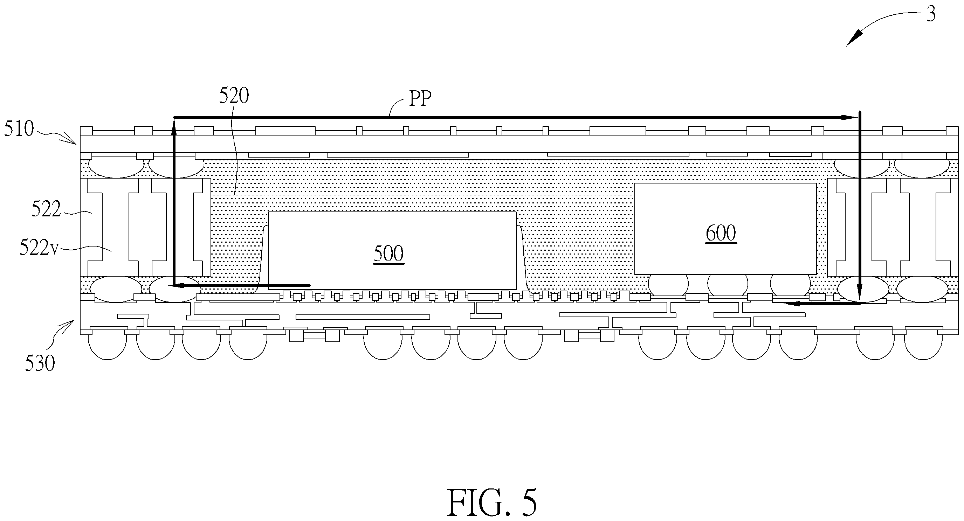

FIG. 5 illustrates an exemplary semiconductor package. As shown in FIG. 5, the semiconductor package 3 comprises an AP die 500 encapsulated by a molding compound 520 and surrounded by a via substrate 522 with a plurality of vias 522v. The AP die 500 and a memory device 600 such as a DRAM package are mounted on the substrate 530 in a side-by-side manner. A top bridge substrate 510 is disposed on the via substrate 522 and the molding compound 520. The signal path PP shows that the signal from the AP die 500 is transmitted through the substrate 530, the via substrate 522 and the vias 522v on the left side, the top bridge substrate 510, the via substrate 522 and the vias 522v on the right side, and the substrate 530 to the memory die 600. The rectangular-shaped or oval-shaped vias 522v as depicted in FIG. 2 and FIG. 3 can significantly improve the electrical performance of the semiconductor package 3 because the connection length of the signal transmission path PP can be reduced.

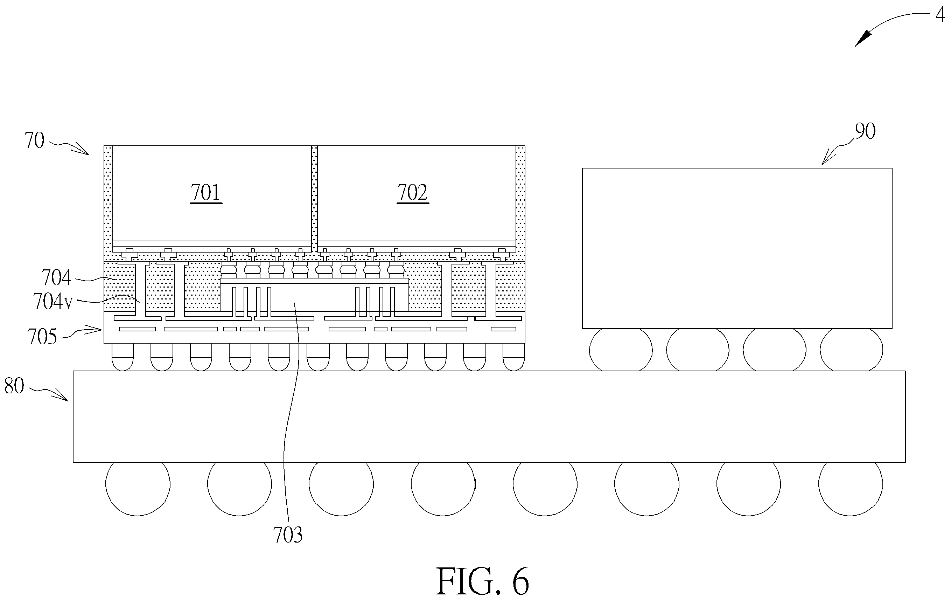

FIG. 6 illustrates another exemplary semiconductor package. As shown in FIG. 6, the semiconductor package 4 comprises a fan-out chip package 70 mounted on a substrate 80. The fan-out chip package 70 and a memory package 90 such as a DRAM package are mounted on the substrate in a side-by-side manner. Preferably, the fan-out chip package 70 may comprise two logic dies 701 and 702 interconnected to a bridge via substrate 703 and a peripheral via structure 704 around the bridge via substrate 703. An RDL structure 705 is provided between the bridge via substrate 703 and the substrate 80 and between the peripheral via structure 704 and the substrate 80. The rectangular-shaped or oval-shaped vias 704v as depicted in FIG. 2 and FIG. 3 can significantly improve the electrical performance of the semiconductor package 4 because the connection length of the signal transmission path can be reduced.

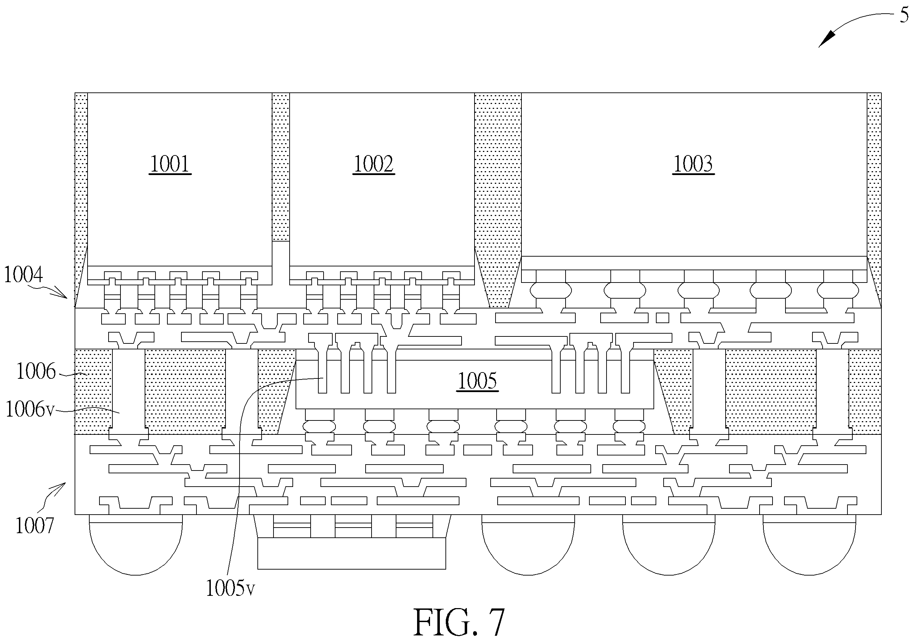

FIG. 7 illustrates still another exemplary semiconductor package. As shown in FIG. 7, the semiconductor package 5 may comprise logic dies 1001 and 1002, and a memory die 1003 interconnected through an RDL structure 1004. The RDL structure 1004 is further interconnected to a through-silicon-via (TSV) die 1005 surrounded by a molding compound 1006. The TSV die 1005 comprises a plurality of through-silicon-vias 1005v penetrating through the TSV die 1005. A plurality of TMVs 1006v is disposed in the molding compound 1006 for signal transmission. The TMVs 1006vmay be electrically connected to the TSV die 1005 through a bottom RDL structure 1007. In addition, the TSV die 1005 may be electrically connected to the logic dies 1001 and 1002, and the memory die 1003 through the bottom RDL structure 1007, the TMVs 1006v and the RDL structure 1004. The rectangular-shaped or oval-shaped vias 1006v as depicted in FIG. 2 and FIG. 3 can significantly improve the electrical performance of the semiconductor package 5 because the connection length of the signal transmission path can be reduced.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package (1), comprising:
a bottom package (10) comprising an application processor, in the following also referred to as AP, die (100) surrounded by a molding compound (110);
a top package (20) mounted on the bottom package (10);
a top re-distribution layer, in the following also referred to as RDL, structure (RT) disposed between the top package (20) and the bottom package (10);
a plurality of through-molding vias, in the following also referred to as TMVs, (110v) disposed in the molding compound (110) for electrically connecting the top package (20) with the AP die (100), wherein each of the plurality of TMVs (110v) has an oval shape or a rectangular shape when viewed from above; and
a bottom RDL structure (RS), wherein the AP die (100) and the plurality of TMVs (110v) are interconnected to the bottom RDL structure (RS).

2. A semiconductor package (2), comprising:
a bottom package (30) comprising a top 2-layer substrate (310), a middle molding compound (320), and a bottom multi-layer substrate (330) to encapsulate an application processor, in the following also referred to as AP, die (300);
a top package (40) mounted on the bottom package (30);
a plurality of through-molding vias, in the following also referred to as TMVs, (320v) disposed in the middle molding compound (320) for electrically connecting the top package (40) with the AP die (300), wherein each of the plurality of TMVs (320v) has an oval shape or a rectangular shape when viewed from above.

3. The semiconductor package (1; 2) according to claim 1 or 2, wherein the top package (20; 40) is a memory package.

4. The semiconductor package (1; 2) according to any one of claims 1 to 3, wherein the TMVs (110v; 320v) have a horizontal pitch (P1) along a first direction (D1) and a vertical pitch (P2) along a second direction (D2), wherein the vertical pitch (P2) is greater than the horizontal pitch (P1).

5. The semiconductor package (1; 2) according to claim 4, wherein the TMVs (110v; 320v) are aligned along the second direction (D2).

6. The semiconductor package (1; 2) according to any one of claims 1 to 5, wherein the TMVs (110v; 320v) are arranged in a staggered manner.

7. The semiconductor package (1) according to claim 1 or any one of claims 3 to 6 in combination with claim 1, wherein a plurality of solder balls (SB) is disposed on a surface of the bottom RDL structure (RS).

8. A semiconductor package (3; 5), comprising:
at least one logic die (500; 1001, 1002) surrounded by a molding compound (520; 1006);
a memory device (600; 1003) disposed in proximity to the at least one logic die (500; 1001, 1002);
a plurality of vias (522v; 1005v) around the at least one logic die (500; 1001, 1002) for electrically connecting the at least one logic die (500; 1001, 1002) to the memory device (600; 1003), wherein each of the plurality of vias (522v; 1005v) has an oval shape or a rectangular shape when viewed from above.

9. The semiconductor package (3; 5) according to claim 8, wherein the vias (522v; 1005v) have a horizontal pitch (P1) along a first direction (D1) and a vertical pitch (P2) along a second direction (D2), wherein the vertical pitch (P2) is greater than the horizontal pitch (P1).

10. The semiconductor package (3; 5) according to claim 9, wherein the vias (522v; 1005v) are aligned along the second direction (D2).

11. The semiconductor package (3; 5) according to any one of claims 8 to 10, wherein the vias (522v; 1005v) are arranged in a staggered manner.

12. The semiconductor package (3) according to any one of claims 8 to 11 further comprising:
a top bridge substrate (510) interconnected to the plurality of vias (522v).

13. The semiconductor package (3) according to any one of claims 8 to 12 further comprising:
a bridge via substrate (522) interconnected to the at least one logic die (500).

14. The semiconductor package (5) according to any one of claims 8 to 13 further comprising:
a through-silicon-via, in the following also referred to as TSV, die (1005) surrounded by the molding compound (1006), wherein the plurality of vias (522v; 1005v) is disposed in the molding compound (1006).
